Europäisches Patentamt

**(19)** European Patent Office

Office européen des brevets

**(11)** Publication number: **0 023 146**
**B1**

**(12)** EUROPEAN PATENT SPECIFICATION

**(45)** Date of publication of patent specification: **30.09.87**

**(21)** Application number: **80302457.9**

**(22)** Date of filing: **21.07.80**

**(51)** Int. Cl.⁴: **H 01 L 21/90,** H 01 L 21/31 // H01L23/52

**(54)** Method of manufacturing a semiconductor device wherein first and second layers are formed.

**(30)** Priority: **23.07.79 JP 92532/79**
**24.07.79 JP 93285/79**

**(43)** Date of publication of application:
**28.01.81 Bulletin 81/04**

**(45)** Publication of the grant of the patent:
**30.09.87 Bulletin 87/40**

**(84)** Designated Contracting States:
**DE FR GB**

**(56)** References cited:
**GB-A-1 523 677**
**US-A-4 073 054**

**IBM TECHNICAL DISCLOSURE BULLETIN, vol.
20, no. 4, September 1977, page 1381, New
York, U.S.A., J.J. COLACINO et al.: "Removal of
quartz spikes over metal lands"**

**IBM TECHNICAL DISCLOSURE BULLETIN, vol.
21, no. 5, October 1978, pages 1868-1869, New
York, U.S.A., T.A. BARTUSH et al.: "Dielectric
isolation planarization"**

**(73)** Proprietor: **FUJITSU LIMITED**
**1015, Kamikodanaka Nakahara-ku
Kawasaki-shi Kanagawa 211 (JP)**

**(72)** Inventor: **Tokitomo, Kazuo
260-12, Kitatakizawa Hachiman, Itsukimachi
Aizuwakamatsu-shi Fukushima 965 (JP)**
Inventor: **Abe, Ryoji
5-5-104, Araisono 4-chome
Sagamihara-shi, Kanagawa 228 (JP)**

**(74)** Representative: **Bedggood, Guy Stuart et al
Haseltine Lake & Co. Hazlitt House 28
Southampton Buildings Chancery Lane
London WC2A 1AT (GB)**

**(56)** References cited:

**IBM TECHNICAL DISCLOSURE BULLETIN, vol.
21, no. 4, September 1978, pages 1518-1519,
New York, U.S.A., A.R. HARDER et al.: "Gas
mixture control permits nonselective reactive
ion etch"**

**0 023 146**

(58) References cited:
**IBM TECHNICAL DISCLOSURE BULLETIN, vol. 19, no. 9, February 1977, pages 3364-3365, New York, U.S.A., W.C. METZGER et al.: "Forming planar integrated circuit metallization"**

**JOURNAL OF VACUUM SCIENCE AND TECHNOLOGY, vol. 13, no. 5, September /October 1976, pages 1023-1029, New York, U.S.A., J.A. BONDUR: "Dry process technology (reactive ion etching)"**

**Description**

This invention relates to methods of manufacturing semiconductor devices with multi-layer wiring structures.

In recent years, efforts have been made to make semiconductor chips and wiring conductors on such chips minutely small and to arrange the conductors in multiple layers for the purpose of increasing compactness and packing density of semiconductor devices such as large scale integration circuits (LSI). In addition, there is a need to increase the reliability of semiconductor devices, certainly reliability should never be reduced, even when effecting such miniaturization of components and realizing multiple layer conductors.

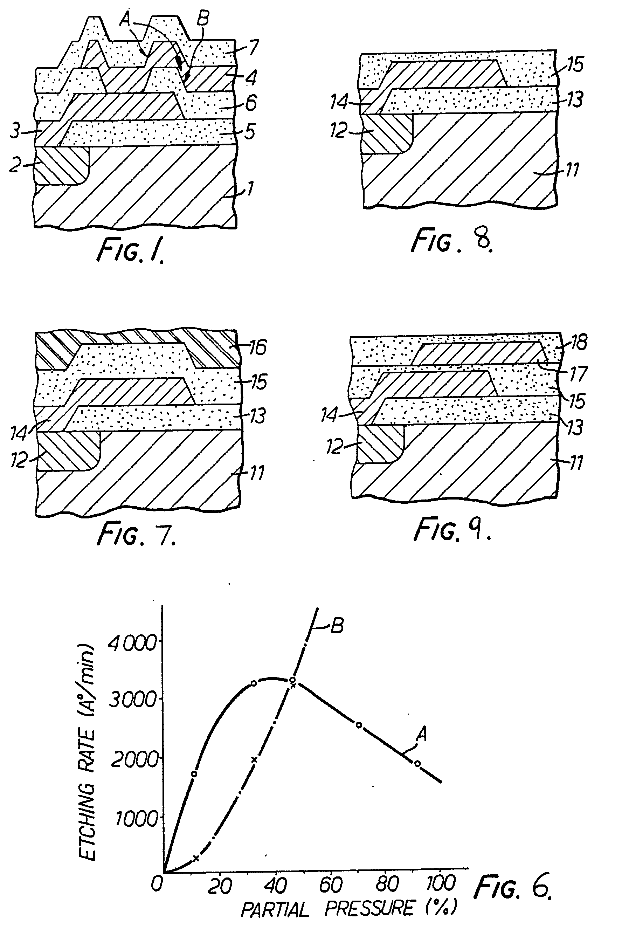

Figure 1 of the accompanying drawings shows in cross-section a part of a semiconductor device with a conventional multiple layer conductor structure.

The device of Figure 1 comprises a silicon substrate 1, a diffusion layer 2, an electrode 3 of aluminium which is also used as an interconnection wiring conductor, an aluminium conductor 4, an insulating layer 5 of $SiO_2$ on the semiconductor substrate, an insulating layer 6 of phospho-silicate glass (PSG) which is between other layers and a surface protection layer 7 of PSG. With such multiple layer wiring conductors as are illustrated in Figure 1, there is a danger of conductor disconnection at steps A, indicated in the Figure and a danger of a short-circuit at step B indicated in the Figure due to cracking of the insulating layer interposed between conductor layers (this insulating layer will be called hereinafter an interposed insulator). In particular, the more layers of conductors there are the greater the possibility of disconnection of conductors.

Japanese Patent Application No. 122559 of 1974 filed on 25th October 1974 and published without examination on 9th June 1976 under Publication No. 66778 of 1976 discloses a method of making even and flat the surface of a semiconductor substrate having projections and dents. The method includes a step of forming on the substrate a film of a material which has an etching rate substantially equal to that of the semiconductor substrate and a step of etching to remove simultaneously the film and at least a part of a projection to make the surface of the semiconductor substrate flat. The use of sputter etching is proposed.

Japanese Patent Application No. 25752 of 1975 filed on 18 October 1975, which was published on 21 April 1977 without examination under Publication No. 49772 of 1977, makes a similar disclosure which differs from the disclosure mentioned above only in that etching is effected by means of a physical etching process utilizing ions.

The two documents mentioned above are particularly directed to a means of making flat a surface of semiconductor substrate having projections and dents. For such a substrate, etching is effected in a manner not only sufficient to remove projections, but is carried out further so that the surface of semiconductor substrate is etched until the substrate surface reaches the bottom of the deepest dent thereby to remove the dents.

IBM Technical Disclosure Bulletin Vol. 20, No. 4, September 1977, page 1381, discloses the removal of quartz spikes over metal lands by covering the spikes with a polymer-containing resist material, then etching by reactive gas plasma etching with a gas mixture of for example $CF_4$ and $O_2$ to produce an etch rate ratio of about 1/1 between the resist and the spikes.

IBM Technical Disclosure Bulletin Vol. 21, No. 5, October 1978, pages 1868 and 1869 discloses a process for the planarization of silicon structures.

A silicon dioxide layer is formed over a silicon structure having trenches therein. A first resist layer is formed over the silicon dioxide layer and processed to become insoluble to a second resist layer which is formed over the first resist layer then reflow baked. The first and second resist layers and the silicon dioxide layer are backetched by reactive ion etching in which the etch rates of the resist and the $SiO_2$ are nearly equivalent.

IBM Technical Disclosure Bulletin, Vol. 19, No. 9, February 1977, pages 3364/3365, discloses reactive ion etching of aluminium using $SiO_2$ or photoresist as a mask.

The Journal of Vacuum Science and Technology, Vol. 13, No. 5, pp. 1023 to 1029, in an article entitled "Dry Process Technology (Reactive Ion Etching)" indicates that quartz can be etched from aluminium with no etching of the aluminium.

According to the present invention there is provided a method of manufacturing a semiconductor device with a multi-layer wiring structure, comprising:—

forming a metal wiring conductor layer over a structured insulation layer,

coating material over the wiring conductor layer, so as to obtain a substantially flat top surface of the coating material, and

effecting a dry etching process using a gaseous mixture with the etching rate of the coating material substantially equal to the etching rate of the metal wiring conductor layer to obtain a substantially flat upper surface.

The present invention is concerned with methods of manufacturing semiconductor devices which reduce, and if possible eliminate altogether, dangers of disconnection and short-circuiting of wiring conductors in the device.

This invention is concerned with avoiding the dangers of disconnection by eliminating steps or differences of levels of layers in a multiple layer wiring conductor structure.

In an embodiment of the present invention a metal wiring conductor layer and a layer of, for example, resinous coating material which is formed over the wiring layer are etched by a dry etching process, such that the wiring layer and the coating material layer are etched at equal rates. The etching may be, for example, reactive sputter etching or plasma etching using a reactive gas which is a gaseous mixture of hydrogen and carbon tetrachloride ($CCl_4$) for example.

Embodiments of this invention use dry etching processes which involve the use of a mixture of gases as reactive gas.

Embodiments of this invention may combine the method according to the invention with processes in which a reactive gas mixture is such that an insulator layer and coating material, of different materials or properties, are etched at substantially equal rates.

In such processes, in the mixture of gases used for dry etching partial pressures of a gas of a fluoride compound (such gas to be called hereinafter a fluoride gas) and an oxygen gas are selected so that in a plasma etching process the etching rate of the insulator layer and that of the coating material are equal, and plasma etching is carried out to expose the surface of the insulator layer in a flat condition.

Furthermore, in such processes, for the coating material, a resinous material, a photoresist or a polymer resinoid such as a resin in the inter-related group of polyimide (such resin to be called hereinafter a polyimide resin) is preferable. For the insulator layer, phospho-silicate glass (PSG) silicon dioxide ($SiO_2$) or silicon nitride ($Si_3N_4$) are preferable. $CF_4$, $C_2F_6$ and $C_2F_5Cl$ are preferable as the fluoride compound used in the aforementioned plasma etching process.

Reference is made, by way of example, to the accompanying drawings, in which:—

Fig. 1, as mentioned above, is a cross-sectional view generally depicting a part of a conventional semiconductor device with a multiple layer conductor structure,

Figs. 2 to 5 are respective cross-sectional views illustrating an embodiment of the present invention,

Fig. 6 is a graph illustrating the relationship between the etching rates of an insulator layer and a resinous coating material and partial pressure of oxygen gas in a gaseous mixture of fluoride gas and oxygen gas,

Figs. 7 to 9 are respective cross-sectional views generally illustrating steps involved in forming multiple layer conductors by processes which may be employed in a method embodying the present invention,

Fig. 10 is a schematic representation of a plasma etching device used to carry out a method embodying the present invention,

Figs. 11 to 12 are respective graphs, similar to the graph of Fig. 6, the resinous coating material with which the graph of Fig. 11 is concerned being different from that with which the graphs of Figs. 6 and 12 are concerned.

Embodiments of the present invention provide methods for obtaining a flat surface on a substrate wherein an electrode or wiring metal layer is etched by a dry etching process simultaneously with a resinous coating material so that finally the metal layer remains only in dents or grooves on the substrate, thereby to form an electrode or wiring pattern.

Figures 2 to 5 are cross-sectional views illustrating such an embodiment of the invention.

In Figure 2 there are shown a silicon substrate 41, an $SiO_2$ film 42, another $SiO_2$ film 44 of a thickness of 0.8 μm formed by chemical vapour deposition with a window opened therethrough in accordance with a predetermined pattern (such film to be called CVD $SiO_2$ film hereinafter), and a wiring conductor layer 43 of for example aluminium approximately 1 μm thick formed by a conventional evaporation technique on the entire surface of the silicon substrate including the surface of the films described above. The surface of said wiring conductor layer 43 forms a concave face at a opening (window) formed in the CVD $SiO_2$ film 44.

In this embodiment a photoresist by a brand name AZ 1870, a product of Tokyo Oka Co., Ltd. is applied by a well known spin coating method and baked at 120°C to form a photoresist film 45 of the thickness of approximately 0.5 μm and having a flat surface.

To the silicon substrate 41 so far worked, reactive sputter etching or plasma etching is carried out for 21 minutes under reaction pressure of $0.33 \times 10^2$ Pa (0.25 Torr) using a reactive gas which is a gaseous mixture of hydrogen ($H_2$) and carbon tetrachloride ($CCl_4$) mixed at a rate of 3/5.

Under the above specified conditions, rates at which the photoresist film 45 and the aluminium layer 43 are etched are approximately in the same order of 60 nm/minute (600 Å/minute) and 65 nm/minute (650 Å/minute) respectively, so that etchings of the film and layer progress substantially uniformly all over the surface to provide a structure shown in Figure 3 wherein the aluminium layer 43 remains only as a thin covering on the CVD $SiO_2$ film.

Thereafter, the mixing rate of the reactive gas mixture of $H_2$ and $CCl_4$ is changed to 4/5 and etching is carried out for approximately 7 minutes.

Under such conditions rates at which the aluminium layer 43 and the CVD $SiO_2$ layer are etched are substantially equal, so that etchings progress substantially uniformly all over the surface to produce a structure shown in Figure 4 wherein the wiring conductor 43 is buried in the CVD $SiO_2$ film 44 with the surface of both being substantially the same height, thus providing a wiring conductor layer approximately 0.7 μm thick and which has a flat surface.

With this embodiment, patterning of the aluminium wiring conductor layer 43 is effected

4

simultaneously with the formation of a buried wiring layer having a flat surface, without resorting to a masking process, so that manufacturing steps are drastically simplified.

After the steps described so far are finished, an insulation layer 46 is formed on top of which a wiring conductor layer 47 is formed, on top of which is formed a further insulation layer 48 as shown in Figure 5. The structure of Figure 5 is comparable to that shown in Figure 9. In order to provide an electrode which serves as outgoing connection wiring similarly to the conductor 14 of Figure 9 (see below), a window may be formed to the insulation layer 46 to interconnect the aluminium layer 43 and the conductor layer 47 by a conventional technique.

In forming multiple layer wiring conductors according to embodiments of the present invention, the processes just described may be carried out alternately with processes described below, or after a buried layer is formed as a first wiring conductor layer, second and subsequent wiring conductor layers may be formed by using the just described processes.

The present invention is not limited to the embodiments indicated above, but may be modified and worked in various manners.

For example, the material of the wiring conductors need not be aluminium, any metal wiring material generally used in the art may be utilized.

Further, the insulation layers are not limited to a combination of CVD $SiO_2$ film as a lower layer and the photoresist film as an upper layer. The lower layer may suitably be selected from PSG film and the like in order to realize insulation between layers of multiple layer wiring conductors, or passivation, or the upper layer may be made of such material as would make the surface of the layer flat. Therefore, a resinous coating material (e.g. photoresist) may be used.

High molecular weight materials such as polyimide or liquid glass might be considered as alternatives, as might a method in which covering by a film of phospho-silicate glass (PSG) is effected, and then the film heated and melted to make it flat.

Polyimide, liquid glass or PSG may also be used in place of resinous coating material in processes as illustrated in Figs. 6 to 9 and 11 and 12 (see below).

With respect to the manner of etching of the above described insulation film and wiring conductor, it is also possible to carry out reactive ion etching or plasma etching as alternatives to reactive sputter etching.

Further, the reactive gas is not limited to a mixture of hydrogen ($H_2$) and carbon tetrachloride ($CCl_4$), a mixture of hydrogen and a compound of chlorine containing hydrogen ($H_2$) such as $CHCl_3$ and $CH_2Cl_2$ or a gaseous mixture of carbon tetrachloride ($CCl_4$) and oxygen ($O_2$) may serve the same purpose if the wiring conductor is aluminium. It may be possible to use a compound of chlorine containing hydrogen in a mixture with oxygen.

With regard to the processes described below, which can be combined with the method according to the invention in order to select a suitable partial pressure of oxygen gas in gaseous mixture of fluoride gas and oxygen gas, experiments were conducted first to determine etching rates of materials to be used in such processes in one method embodying this invention; namely etching rates of an insulator and a resinous coating material, under various partial pressures were studied.

For example, $C_2F_6$ gas, a negative photoresist known by the brand name OMR-83, a product of Tokyo Oka Co., Ltd. of Kawasaki City, Kanagawa Prefecture, Japan, and phospho-silicate glass (PSG) were picked respectively as examples of fluoride gas, resinous coating material and insulator to be used, and etching rates were determined in plasma etching conditions set up as follows:

| | |
|---|---|
| $C_2F_6$ gas pressure within a reactor tube: | $0.66 \times 10^2$ Pa (0.5 Torr) |
| Etching time: | 3 minutes |
| Applied high frequency power: | 300 watt |
| Temperature within the reactor tube when etching commenced: | 120°C |
| Phosphorus concentration of PSG: | 14% |

The results of the experiments are reflected in the graph of Figure 6 in which the line A relates to the PSG, the line B relates to the negative resist, and the ratio of the partial pressure of oxygen gas to the total pressure of the mixture of fluoride gas and oxygen gas corresponding to a point where the lines A and B intersect indicates the condition under which the etching rates of the insulator and the resinous coating material are equal.

The resinous coating material is etched through an oxidation reaction by the plasma of the oxygen gas. The term "etching" herein includes such an oxidation process of a resinous material to remove a layer of the material gradually.

Next, the steps involved in forming multiple layer wiring conductors in a semiconductor device by processes which may be combined with the method according to the present invention will be explained.

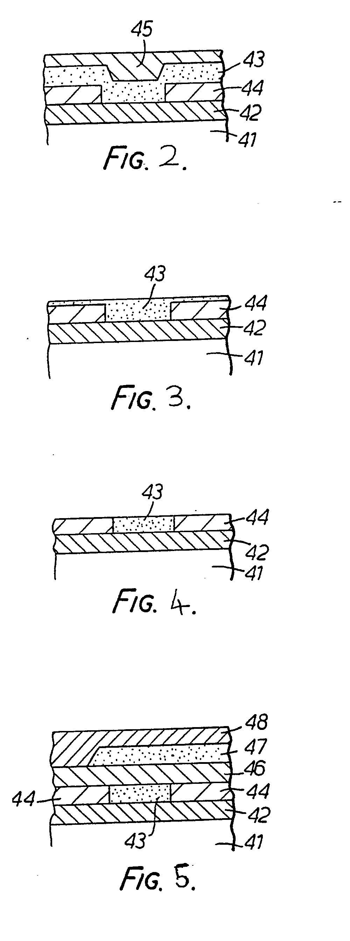

As shown in Figure 7, on a semiconductor substrate 11 and a diffusion layer 12 formed therein, an insulation layer 13 approximately 0.5 μm thick (which is a layer of $SiO_2$ where the semiconductor substrate is of single-crystal silicon) and an electrode/interconnection wiring conductor layer 14 of aluminium for example approximately 1.0 μm thick are formed. Thereafter, an interposed insulator 15 of PSG for example approximately 2.0 μm thick, thicker than the conductor layer 14, is formed by chemical vapour deposition or an evaporation process. On said interposed insulator 15, a layer of resinous coating material, for example negative photoresist, approximately 1.5 μm thick, is so formed by a conventional spin coating process that its surface becomes flat.

Thereafter, the substrate 11 is placed in a conventional plasma etching apparatus to effect plasma etching under the conditions specified above, with fluoride gas and oxygen gas being supplied under various partial pressures as described before.

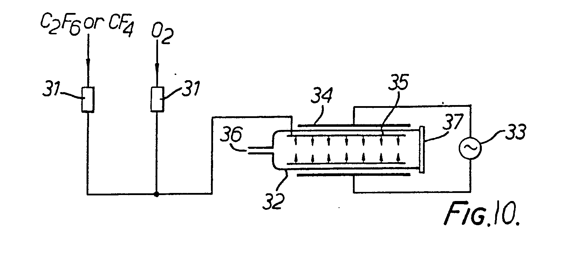

The etching apparatus is schematically depicted in Figure 10.

In this apparatus $C_2F_6$, $CF_4$ or $C_2F_5Cl$ and $O_2$ are supplied via flow meters 31 to a quartz furnace tube 32 provided with gas nozzles 35 and sealed by a lid 37. A generator 33 of r.f. power of for example 13.56 MHz is connected to a plasma generator 34. An exhaust 36 is connected to a vacuum pump (not shown) to keep the pressure within the tube at a predetermined value, for example $1.33 \times 10^2$ Pa (1 Torr). Details of the device and explanation thereof are omitted because the structure and operation of such a device are generally known in the art.

In such an etching apparatus; plasma etching is carried out under the predetermined partial pressure values of the oxygen gas and the fluoride gas, both of which are about $0.66 \times 10^2$ Pa (0.5 Torr) as shown in Figure 6. The etching rates of the PSG and the photoresist are equal under these conditions.

There are two ways in which the above described plasma etching can be terminated. One way is to end the etching at exactly the moment at which the surface of the conductor 14 is exposed. Thereafter, PSG is deposited again until the PSG layer is about 1.0 μm thick. The condition of the surface of the interposed insulator 15 at this time is as shown in Figure 8.

The other way is to conclude etching when a condition as shown in Figure 8 is reached wherein the surface of the interposed insulator 15 is flat. By this time, the interposed insulator 15 would have been etched off to approximately 1.0 μm in thickness.

Termination of the etching is determined in either case by first calculating the length of time that will be required for etching off the interposed insulator to 1.0 μm in thickness, then confirming the actual etching off thereof.

In a similar manner, a second conductor layer 17 and an interposed insulator layer 18 are formed to produce multiple layer wiring conductors as shown in Figure 9, devoid of steps such as A and B in Figure 1 which are present in the conventional art. In order to interconnect the conductors 14 and 17 of Figure 9, the conductor 17 is formed after a window (not shown) has been opened in the interposed insulator 15.

Reverting to the relationship between the etching rates of PSG and the resinous coating material and the partial pressures of the gaseous mixture used, further experiments were conducted.

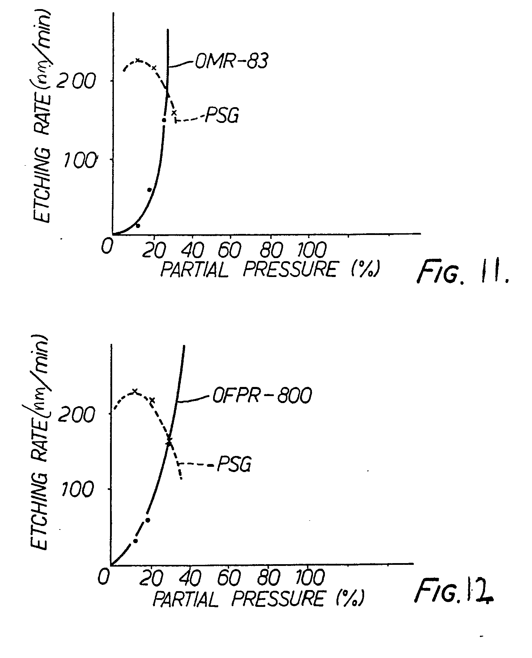

In one experiment, the results of which are shown in Figure 11, the negative photoresist OMR-83 mentioned above, and PSG were again selected, but a gaseous mixture of $CF_4$ and $O_2$ was used. Total pressure of the gaseous mixture was set at $1.33 \times 10^2$ Pa (1 Torr) and r.f. power at 300 W. In another experiment, the results of which are shown in Figure 12, PSG and a negative photoresist known by the brand name of OFPR-800, a product of Tokyo Oka Co., Ltd. were selected, using the same gaseous mixture as in the experiments of Figure 11. Total pressure of the gaseous mixture was set at $1.33 \times 10^2$ Pa (1 Torr) and r.f. power at 300 W.

The horizontal axis of the graphs in Figure 11 and 12 represents the ratio of the partial pressure of oxygen gas to the total pressure given by the oxygen gas and fluoride compound gas in the etching apparatus, as in Figure 6.

As has been described, conventional wet etching is replaced by the dry etching because of the plasma etching so that there is no need to use a chemical solution for polishing. There will be no need therefore to be concerned about the problems of contamination by alkaline metals contained in such solution, and a device and process for grinding and polishing will become unnecessary in the process of the invention.

It should be appreciated that it may be possible to substitute for oxygen $O_2$ in a gaseous mixture used as reaction gas in etching in embodiments of this invention. For example, other types of oxidising gases containing non-essential ingredients could be considered.

**Claims**

1. A method of manufacturing a semiconductor device with a multi-layer wiring structure, comprising:—

forming a metal wiring conductor layer over a structured insulation layer

coating resinous material over the wiring conductor layer, so as to obtain a substantially flat top surface of the coating material, and

effecting a dry etching process using a gaseous mixture with the etching rate of the resinous coating material substantially equal to the etching rate of the metal wiring conductor layer to obtain a substantially flat upper surface.

2. A method as claimed in claim 1, further comprising forming a further insulation layer on top of said flat upper surface and forming a further wiring conductor layer on top of the second insulation layer.

3. A method as claimed in claim 1 or 2, wherein the wiring conductor layer is of aluminium.

4. A method as claimed in claim 1, 2 or 3, wherein the dry etching process comprises reactive sputter etching, reactive ion etching or plasma etching.

6

5. A method as claimed in claim 3 or 4, wherein the gaseous mixture comprises a gaseous mixture of hydrogen with either carbon tetrachloride ($CCl_4$) or $CHCl_3$ or $CH_2Cl_2$, or comprises a gaseous mixture of $CCl_4$ and oxygen.

6. A method as claimed in any one of claims 1 to 5, wherein the said metal wiring conductor layer is formed on a layer of phosphosilicate glass, or on a layer of $SiO_2$ deposited by chemical vapour deposition.

7. A method as claimed in any preceding claim, wherein the coating material is a photoresist.

8. A method as claimed in any preceding claim, comprising:

forming a wiring conductor layer different from the said metal wiring conductor layer of the preceding claims,

forming an insulator layer over the different wiring conductor layer, with a thickness greater than that of the different wiring conductor layer,

coating covering material over the different wiring conductor layer and the insulator layer, so as to obtain a substantially flat upper surface of the covering material,

effecting non-selective dry etching using a gaseous mixture with the etching rate of the covering material substantially equal to the etching rate of the insulator layer, to obtain a substantially flat upper surface of the insulator layer, and

forming another wiring conductor layer on the flat upper surface of the insulator layer.

9. A method as claimed in claim 8, wherein the non-selective dry etching process is a plasma etching process in which a gaseous mixture of a fluoride compound gas and an oxygen gas is employed, the partial pressures of the gases in the mixture being so selected that the covering material and the insulator layer are etched at substantially equal rates.

10. A method as claimed in claim 9, wherein the fluoride compound gas is $C_2F_6$ or $CF_4$ or $C_2F_5Cl$.

11. A method as claimed in any one of claims 8, 9 and 10, wherein the insulator layer comprises either phospho-silicate glass, silicon dioxide or silicon nitride.

12. A method as claimed in any one of claims 8 to 11, wherein the covering material is a resinous material.

13. A method as claimed in any one of claims 8 to 11, wherein the covering material is of photoresist or polyimide, or liquid glass.

14. A method as claimed in any one of claims 8 to 11, wherein the covering material is of phosphosilicate glass heated and melted.

**Patentansprüche**

1. Verfahren zur Herstellung einer Halbleitervorrichtung mit einer Mehrfachschicht-Verdrahtungsstruktur, mit:

Bildung einer Metallverdrahtungsleiterschicht über einer strukturierten Isolationsschicht,

Überziehen eines Harzmaterials über der Verdrahtungsleiterschicht, um so eine im wesentlichen flache obere Oberfläche des Überzugmaterials zu erhalten und

Durchführen eines Trockenätzverfahrens unter Verwendung einer Gasmischung mit einer Ätzrate des Harzüberzugmaterials im wesentlichen gleich der Ätzrate der Metallverdrahtungsleiterschicht, um eine im wesentlichen flache obere Obefläche zu erhalten.

2. Verfahren nach Anspruch 1, ferner mit Bildung einer weiteren Isolationsschicht auf der Oberseite der flachen oberen Oberfläche und Bildung einer weiteren Verdrahtungsleiterschicht auf der Oberseite der zweiten Isolationsschicht.

3. Verfahren nach Anspruch 1 oder 2, bei dem die Verdrahtungsschicht aus Aluminium besteht.

4. Verfahren nach Anspruch 1, 2 oder 3, bei der das Trockenätzverfahren reaktive Zerstäubungsätzung, reaktive Ionenätzung oder Plasmaätzung umfaßt.

5. Verfahren nach Anspruch 3 oder 4, bei dem die Gasmischung eine gasförmige Mischung aus Wasserstoff mit entweder Kohlenstofftetrachlorid ($CCl_4$) oder $CHCl_3$ oder $CH_2Cl_2$, oder eine gasförmige Mischung aus $CCl_4$ und Sauerstoff umfaßt.

6. Verfahren nach einem der Ansprüche 1 bis 5, bei dem die genannte Metallverdrahtungsleiterschicht auf einer Schicht aus Phosphorsilikatglas oder auf einer Schicht aus $SiO_2$, die durch chemische Dampfabscheidung niedergeschlagen ist, gebildet ist.

7. Verfahren nach einem der vorhergehenden Ansprüche, bei dem das Überzugmaterial ein Photoresist ist.

8. Verfahren nach einem der vorhergehenden Ansprüche, mit:

Bildung einer Verdrahtungsleiterschicht, die von der genannten Metallverdrahtungsleiterschicht der vorhergehenden Ansprüche unterschiedlich ist,

Bildung einer Isolatorschicht über der unterschiedlichen Verdrahtungsleiterschicht, mit einer Dicke größer als diejenige der unterschiedlichen Verdrahtungsleiterschicht,

Überziehen eines Abdeckmaterials über die unterschiedliche Verdrahtungsleiterschicht und die Isolatorschicht, um so eine im wesentlichen flache obere Oberfläche des Überzugmaterials zu erhalten,

Bewirken einer nichtselektiven Trockenätzung unter Verwendung einer Gasmischung mit einer Ätzrate des Abdeckmaterials, die im wesentlichen gleich der Ätzrate der Isolatorschicht ist, um eine im wesentlichen flache obere Oberfläche der Isolatorschicht zu erhalten, und

Bildung einer anderen Verdrahtungsleiterschicht auf der flachen Oberfläche der Isolatorschicht.

7

## 0 023 146

9. Verfahren nach Anspruch 8, bei dem das nichtselektive Trockenätzverfahren ein Plasmaätzverfahren ist, bei dem eine gasförmige Mischung aus einem Fluorverbindungsgas und einem Sauerstoffgas verwendet wird, die Teildrücke der Gase in der Mischung so gewählt sind, daß das Abdeckmaterial und die Isolatorschicht mit im wesentlichen gleichen Raten geätzt werden.

10. Verfahren nach Anspruch 9, bei dem das Fluorverbindungsgas $C_2F_6$ oder $CF_4$ oder $C_2F_5Cl$ ist.

11. Verfahren nach einem der Ansprüche 8, 9 und 10, bei dem die Isolatorschicht entweder Phosphorsilikatglas, Siliziumdioxid oder Siliziumnitrid umfaßt.

12. Verfahren nach einem der Ansprüche 8 bis 11 bei dem das Abdeckmaterial ein Harzmaterial ist.

13. Verfahren nach einem der Ansprüche 8 bis 11, bei dem das Abdeckmaterial ein Photoresist oder Polyimid oder flüssiges Glas ist.

14. Verfahren nach einem der Ansprüche 8 bis 11, bei dem das Abdeckmaterial aus erhitztem und geschmolzenem Phosphorsilikatglas besteht.

## Revendications

1. Procédé de fabrication d'un dispositif à semiconducteur ayant une structure multicouche de câblage, comprenant:

la formation d'une couche métallique conductrice de câblage sur une couche d'isolement ayant une structure,

le revêtement d'un matériau résineux sur la couche conductrice de câblage afin qu'une surface supérieure sensiblement plate du matériau de revêtement soit obtenue, et

l'exécution d'une opération d'attaque à sec à l'aide d'un mélange gazeux, la vitesse d'attaque du matériau résineux de revêtement étant sensiblement égale à la vitesse d'attaque de la couche conductrice métallique de câblage afin qu'une face supérieure sensiblement plate soit obtenue.

2. Procédé selon la revendication 1, comprenant en outre la formation d'une couche isolante supplémentaire sur la surface isolante plate et la formation d'une couche conductrice supplémentaire de câblage sur la seconde couche isolante.

3. Procédé selon l'une des revendications 1 et 2, dans lequel la couche conductrice de câblage est l'aluminium.

4. Procédé selon l'une quelconque des revendications 1, 2 et 3, dans lequel l'opération d'attaque à sec est une attaque par pulvérisation réactive, une attaque par des ions réactifs ou une attaque dans un plasma.

5. Procédé selon l'une des revendications 3 et 4, dans lequel le mélange gazeux est un mélange gazeux d'hydrogène avec soit du tétrachlorure de carbone ($CCl_4$), soit $CHCl_3$, soit $CH_2Cl_2$, ou est un mélange gazeux de $CCl_4$ et d'oxygène.

6. Procédé selon l'une quelconque des revendications 1 à 5, dans lequel la couche conductrice métallique de câblage est formée sur une couche d'un verre de phospho-silicate ou sur une couche de $SiO_2$ déposée par dépôt chimique en phase vapeur.

7. Procédé selon l'une quelconque des revendications précédentes, dans lequel le matériau de revêtement est une réserve photographique.

8. Procédé selon l'une quelconque des revendications précédentes, comprenant:

la formation d'une couche conductrice de câblage différente de la couche conductrice métallique de câblage des revendications précédentes,

la formation d'une couche isolante sur la couche conductrice différente de câblage, avec une épaisseur supérieure à celle de la couche conductrice différente de câblage,

le revêtement d'un matériau de recouvrement sur la couche conductrice différente de câblage et la couche isolante afin qu'une surface supérieure sensiblement plate du matériau de recouvrement soit obtenue,

l'exécution d'une attaque à sec non sélective à l'aide d'un mélange gazeux, la vitesse d'attaque du matériau de recouvrement étant sensiblement égale à la vitesse d'attaque de la couche isolante, afin qu'une surface supérieure sensiblement plate de la couche isolante soit obtenue, et

la formation d'une autre couche conductrice de câblage sur la surface supérieure plate de la couche isolante.

9. Procédé selon la revendication 8, dans lequel l'opération d'attaque à sec non sélective est une opération d'attaque par un plasma dans laquelle un mélange gazeux d'un fluorure gazeux et d'oxygène gazeux est utilisé, les pressions partielles des gaz dans le mélange étant choisies de manière que le matériau de recouvrement et la couche isolante soient attaqués pratiquement avec des vitesses égales.

10. Procédé selon la revendication 9, dans lequel le fluorure gazeux est $C_2F_6$ ou $CF_4$ ou $C_2F_5Cl$.

11. Procédé selon l'une quelconque des revendications 8, 9 et 10, dans lequel la couche isolante est soit un verre de phosphosilicate, soit du bioxyde de silcium, soit du nitrure de silicium.

12. Procédé selon l'une quelconque des revendications 8 à 11, dans lequel le matériau de recouvrement est un matériau résineux.

13. Procédé selon l'une quelconque des revendications 8 à 11, dans lequel le matériau de recouvrement est une réserve photographique ou un polyimide ou un verre liquide.

14. Procédé selon l'une quelconque des revendications 8 à 11, dans lequel le matériau de recouvrement est un verre de phosphosilicate qui a été chauffé et fondu.

8

0 023 146

FIG. 1.

FIG. 8.

FIG. 7.

FIG. 9.

FIG. 6.

ETCHING RATE (A°/min)

PARTIAL PRESSURE (%)

1

*45*

*43*

*44*

*42*

*41*

*FIG. 2.*

*43*

*44*

*42*

*41*

*FIG. 3.*

*43*

*44*

*42*

*41*

*FIG. 4.*

*48*

*47*

*46*

*44*

*42*

*44*

*43*

*41*

*FIG. 5.*

$C_2F_6$ or $CF_4$    $O_2$

31    31

34    35

36    37    33

32

*FIG.10.*

FIG. II.

FIG. 12